# EUROPÄISCHE PATENTSCHRIFT

(11) **EP 0 863 547 B1**
(45) Veröffentlichungstag und Bekanntmachung des Hinweises auf die Patenterteilung: **23.08.2006**
(21) Anmeldenummer: 98810090.5
(22) Anmeldetag: 09.02.1998
(51) Int. Cl.: H01L 23/051, H01L 23/64, H01L 23/36

(54) **Gateeinheit für einen hart angesteuerten GTO**
Gate unit for a hard-driven GTO
Unité de porte pour un GTO à commande dure

(30) Priorität: 05.03.1997 DE 19708873
(43) Veröffentlichungstag der Anmeldung: 09.09.1998
(73) Patentinhaber: ABB Schweiz AG, 5400 Baden (CH)
(72) Erfinder: Grüning, Horst, Dr., 5430 Wettingen (CH); Piccioni, Enrico, 5406 Baden-Dättwil (CH)
(74) Vertreter: ABB Patent Attorneys

(56) Entgegenhaltungen:
- EP-A- 0 328 778
- EP-A- 0 588 026
- EP-A- 0 785 627
- P.STEIMER E.A.: "Serienschaltung von GTO-Thyristoren für Frequenzumrichter hoher Leistung" ABB TECHNIK, Nr. 5, 1996, Seiten 14-20, XP002113037

## Beschreibung

### TECHNISCHES GEBIET

Die vorliegende Erfindung bezieht sich auf das Gebiet der Leistungselektronik. Sie betrifft eine Gateeinheit für einen hart angesteuerten GTO, bei welcher Gateeinheit zumindest ein Teil der für die Ansteuerung benötigten elektronischen Bauelemente auf einer Leiterplatte angeordnet und von einer Abschirmung umgeben ist, welche Leiterplatte zur niederinduktiven Kontaktierung den GTO in einer zwischen der Anodenseite und Kathodenseite des GTO liegenden Ebene parallel zum Halbleitersubstrat des GTO umschliesst und mit dem Kathodenkontakt und dem Gateanschluss des GTO direkt verbunden ist.

Eine solche Gateeinheit ist z.B. aus der Druckschrift ABB Technik, Heft 5/96, Seiten 14-20 (siehe insbesondere die dortige Abb. 5), bekannt.

Eine ähnliche Gateeinheit zeigt EP-A-0 328 778 (Abb.5).

Bei der Anwendung von Hochleistungs-Halbleiterbauelementen, die in Form von GTOs (Gate Turn-Off Thyristoren) vorliegen, hat die sogenannte harte Ansteuerung in den letzten Jahren ein stark steigendes Interesse gefunden. Gerade bei der Serienschaltungen von mehreren GTOs, wie sie z.B. bei Hochleistungsstromrichtern für Netzkupplungen oder dgl. notwendig sind, sorgt die harte Ansteuerung dafür, dass die einzelnen GTOs der Serieschaltung sehr präzise zur gleichen Zeit abgeschaltet werden können und damit keine schädlichen Ueberspannungen an einzelnen GTOs auftreten. Bei der harten Ansteuerung wird der GTO mit einem Gatestrom I_{G} sehr hoher Steilheit (z.B. 3 kA/µs anstelle von 30 A/µs bei herkömmlicher Ansteuerung) angesteuert.

Um derartige Steilheiten realisieren zu können, muss der Gatekreis des GTO extrem niederinduktiv (< 5 nH) ausgelegt sein, was nicht nur bei der zur Ansteuerung verwendeten Gateeinheit (Gate Unit GU), sondern auch beim GTO selbst besondere konstruktive Massnahmen und Vorkehrungen erforderlich macht. Einzelheiten zur harten Ansteuerung können der eingangs genannten Druckschrift, der Europäischen Patentanmeldung EP-Al-0 489 945, der WO-93/09600 oder dem Artikel von H. Grüning et al. "High Power Hard-Driven GTO Module for 4.5 kV/3 kA Snubberless Operation", PCIM '96, Nürnberg, Deutschland, 21.-23. Mai 1996, entnommen werden, deren Inhalt ausdrücklich Teil der Offenbarung dieser Anmeldung sein soll.

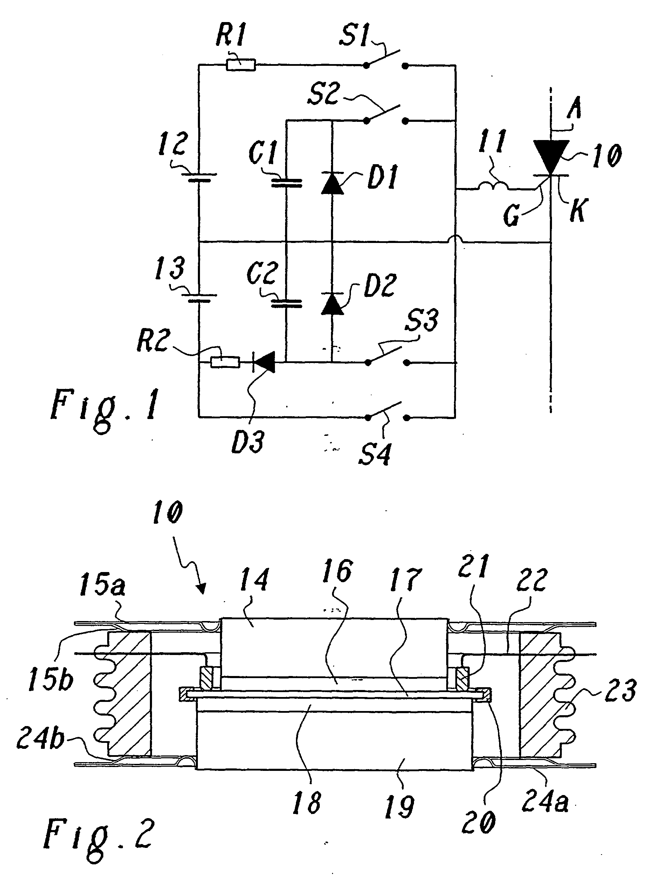

Eine bekannte GU für die harte Ansteuerung, für die ein beispielhaftes Prinzipschaltbild in Fig. 1 wiedergegeben ist, besteht im wesentlichen aus:
- einem Ausschaltkanal, mit einem Hochstromschalter (S3), aus mehreren Elektrolytkondensatoren (Elkos) gebildeten Kondensatorbatterie (C2) mit antiparalleler Diode (D2), einer Spannungsquelle (13) und einer Ansteuerung (nicht dargestellt); ein zweiter Schalter (S4) hält den GTO 10 abgeschaltet; zusätzlich ist noch ein Serieschaltung aus Widerstand (R2) und Diode (D3) vorgesehen;
- einem Einschaltkanal, mit einem Mittelstromschalter (S2), einer Spannungsquelle (12) und einer Pulsstromquelle (Kondensator C1 mit antiparalleler Diode D1); ein zweiter Schalter S1 mit Serienwiderstand R1 hält den GTO 10 eingeschaltet;
- einer Logik (nicht in Fig. 1 dargestellt), mit einem fiberoptischen Eingang, Verstärker- und Verzögerungsstufen und einem Potentialwandler; und
- ggf. einer Rückmeldungsvorrichtung.

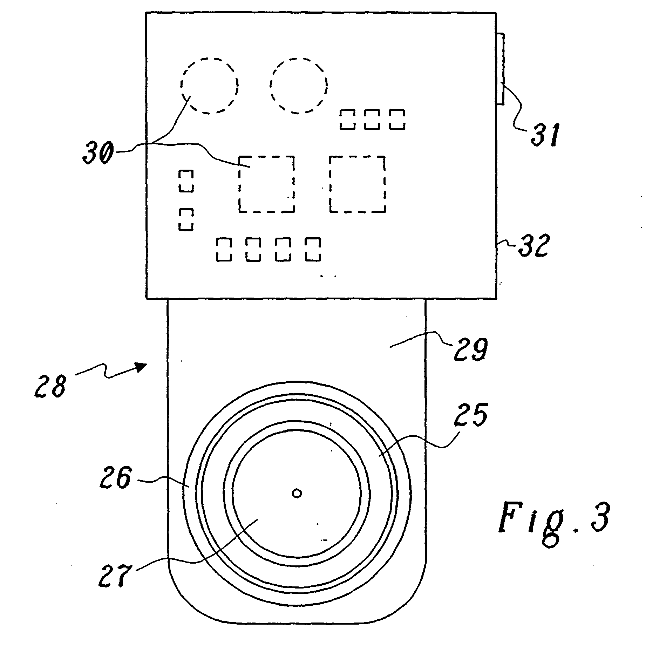

Die konstruktive Ausgestaltung der bekannten GUs ergibt sich aus dem Photo in Abb. 5 der eingangs genannten Druckschrift bzw. der schematischen Darstellung in Fig. 3 der vorliegenden Anmeldung. Die gesamte Logik, die Leistungsstufen des Einschaltkanals und die Stufen des Ausschaltkanals (gestrichelt angedeutete Bauelemente 30 in Fig. 3) der Gateeinheit 28 befinden sich räumlich dicht beisammen auf einer Leiterplatte (Platine) 29 seitlich in einiger Entfernung vom eigentlichen GTO 25 angeordnet. Die Gateeinheit 28 mit den Bauelementen 30 ist von einem separaten Gehäuse 32 umgeben und entsprechend nach aussen abgeschirmt. Die Gateeinheit 28 ist über einen Leiterplattenteil, der den daneben angeordneten GTO 25 umschliesst, mit dem GTO 25 verbunden. Der Anodenkontakt 27 des GTO 25 ist nach oben frei zugänglich. Der (ringförmige) Gateanschluss des GTO 25 ist direkt mit der Leiterplatte 29 verbunden. Für die Einspeisung von Steuersignalen über Lichtleiter ist ein Anschlussbereich 31 vorgesehen.

Der GTO 25 selbst ist ein koaxial aufgebautes Bauelement. Ein (bekannter) beispielhafter innerer Aufbau eines solchen GTO ist in Fig. 2 im teilweise schraffierten Schnitt gezeigt. Das Herzstück des GTO 10 ist ein scheibenförmiges Halbleitersubstrat 17, auf welchem in bekannter Weise eine Vielzahl von Einzelelementen nebeneinander angeordnet sind. Das Halbleitersubstrat 17 ist randseitig mit einer Randpassivierung 20 versehen. Es liegt zwischen einem scheibenförmigen Anodenkontakt 14 und einem scheibenförmigen Kathodenkontakt 19, die im eingebauten Zustand des GTO 10 mit Druck gegen das (metallisierte) Halbleitersubstrat 17 gepresst werden, um den elektrischen und thermischen Kontakt zur Anode A bzw. Kathode K herzustellen. Zum Ausgleich unterschiedlicher Ausdehnungskoeffizienten sind in der Regel zwischen den Kontakten 14, 19 und dem Halbleitersubstrat 17 noch Mo-Scheiben 16 und 18 vorgesehen. Zur Kontaktierung des Gates G ist ein ringförmiger, niederinduktiver Gatekontakt 21 vorgesehen, der über einen kreisringförmigen Gateanschluss 22 durch das keramische Isoliergehäuse 23 radial nach aussen geführt ist. Das Isoliergehäuse 23 ist oben und unten durch angesetzte Flansche 15b, 24b und mit den Flanschen verschweisste Deckel 15a, 24a nach aussen hin hermetisch abgedichtet.

Durch die bekannte Gateeinheit 28 mit GTO 25 gemäss Fig. 3 wird die gewünschte niederinduktive Verbindung zwischen Ansteuerung und Leistungshalbleiter realisiert. Die Streuinduktivität im Gatekreis (11 in Fig. 1) beträgt weniger als 5 nH. Durch die direkte Verbindung von GTO 25 und Gateeinheit 28 über die starre Leiterplatte 29 ergibt sich insgesamt eine Baugruppe, die als Einheit produziert und getestet und in den Stapel der Serieschaltung eingeschoben werden kann. Die Ansteuerelektronik ist dabei durch das allseitig geschlossene Gehäuse 32 gut gegen EMI abgeschirmt.

Diesen gewichtigen Vorteilen stehen bei der bekannten Gateeinheit jedoch einige Nachteile gegenüber:
- Die Elektronik der Gateeinheit konzentriert sich zu einem Gebilde, das erhebliches Volumen und Masse besitzt; hierzu tragen insbesondere die als Stromquelle für den Gatestrom verwendeten Elkos bei; für einen GTO mit den Leistungsdaten 4kA/4,5kV werden z.B. 40 Elkos mit je 1500µF/35V benötigt, für einen (kleineren) rückwärtsleitenden GTO mit 600A/6kV etwa 10 Elkos mit je 1500µF/35V; dieses Gebilde befindet sich an einer Seite von GTO und Kühler; es muss zusätzlichen Abstand vom Kühler halten, damit es dem anodenseitigen Kühler nicht zu nahe kommt (Isolationsabstand). Damit ist es mechanisch äusserst schwierig zu befestigen und wenig robust gegen über Rüttelbewegungen bzw. Schwingungen.
- Die Befestigung ist kostenintensiv.
- Die Gateeinheit vergrössert das Bauvolumen des Umrichters erheblich, weil sie einen grossen, nur schwer ausfüllbaren Raum aufspannt.

### DARSTELLUNG DER ERFINDUNG

Es ist daher Aufgabe der Erfindung, eine Gateeinheit zu schaffen, welche diese Nachteile vermeidet und unter Beibehaltung eines niederinduktiven Anschlusses und einer guten Abschirmung kompakt im Aufbau, leicht und kostengünstig aufzubauen ist und sich durch eine hohe mechanische Stabilität auszeichnet.

Die Aufgabe wird bei einer Baugruppe gemäß Anspruch 1 Art dadurch gelöst, dass die Bauelemente der Gateeinheit auf der Leiterplatte in unmittelbarer Nähe des GTO angeordnet sind. Durch die Anordnung der Bauelemente bzw. der Ansteuerelektronik direkt am GTO werden seitlich weit herausstehende, schwingungsfähige Massen vermieden, wodurch die mechanische Stabilität deutlich erhöht wird. Gleichzeitig spart die Gateeinheit durch den kompakten Aufbau um den GTO herum Platz ein. Zugleich wird die Baugruppe aus GTO und Gateeinheit handlicher und lässt sich besser ein- und ausbauen.

Eine erste bevorzugte Ausführungsform der erfindungsgemässen Gateeinheit zeichnet sich dadurch aus, dass der GTO kathodenseitig an einen Kühler angrenzt, dass die Leiterplatte seitlich über den kathodenseitigen Kühler hinausragt, dass die auf der Leiterplatte angeordneten elektronischen Bauelemente eine Mehrzahl von Kondensatoren, insbesondere Elektrolytkondensatoren, umfassen, welche innerhalb der Gateeinheit eine Stromquelle für einen impulsförmigen Gatestrom des GTO bilden, und dass die Kondensatoren auf dem den Kühler überragenden Teil der Leiterplatte in unmittelbarer Nähe des Kühlers angeordnet sind. Hierdurch können selbst die relativ grossvolumigen und schweren Kondensatoren so nahe am GTO angeordnet werden, dass sich ein wesentlicher Gewinn an mechanischer Stabilität ergibt.

Eine weitere bevorzugte Ausführungsform der Gateeinheit nach der Erfindung ist dadurch gekennzeichnet, dass die Bauelemente überwiegend auf der dem Kühler bzw. der Kathodenseite des GTO zugewandten Seite der Leiterplatte angeordnet sind, dass die Leiterplatte von dem kathodenseitigen Kühler beabstandet ist, und dass ein Teil der Bauelemente zwischen der Leiterplatte und dem Kühler angeordnet sind. Hierdurch wird erreicht, dass der kathodenseitige Kühler material- und platzsparend gleichzeitig zum Schutz und zur Abschirmung insbesondere kleinerer (z.B. SMD-) Bauelemente eingesetzt wird.

Gemäss einer weiteren Ausführungsform der Erfindung wird die Abschirmung dadurch vervollständigt, dass die Leiterplatte auf der der Kathodenseite des GTO abgewandten Seite mit einer Metallisierung versehen ist, und dass die Metallisierung als Abschirmung der Gateeinheit verwendet wird.

Gemäss einer anderen Ausführungsform der Erfindung wird die Abschirmung dadurch vervollständigt, dass zur Abschirmung der Bauelemente eine elektrisch leitende Schale vorgesehen ist, welche den GTO seitlich umschliesst und die mit den Bauelementen bestückte Leiterplatte auf der der Kathodenseite des GTO abgewandten Seite überdeckt.

Eine weitere bevorzugte Ausführungsform der Gateeinheit nach der Erfindung ist dadurch gekennzeichnet, dass die Leiterplatte seitlich über den kathodenseitigen Kühler hinausragt, dass die Schale mit ihrer Seitenwand auch einen Teil des Kühlers umschliesst, derart, dass zwischen dem Kühler und der Schale bzw. der Seitenwand der Schale ein umlaufender Zwischenraum frei bleibt, und dass ein Teil der Bauelemente in dem Zwischenraum angeordnet sind. Hierdurch wird auf einfache Weise ein geschützter und abgeschirmter Platz geschaffen, in welchem insbesondere die grösseren Bauelemente der Gateeinheit wie z.B. die Elkos des Ausschaltkanals (C2 in Fig.1) sicher untergebracht werden können.

Eine weitere bevorzugte Ausführungsform, die sich durch eine besonders hohe mechanische Stabilität auszeichnet, ist dadurch gekennzeichnet, dass an der Leiterplatte Befestigungselemente angeordnet sind, mittels derer die Leiterplatte an dem darunterliegenden Kühler befestigbar ist, und/oder dass zusätzliche Mittel zur Abstützung der Leiterplatte an der Schale vorgesehen sind.

Weitere Ausführungsformen ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 1: ein beispielhaftes Prinzipschaltbild einer harten Ansteuerung für einen GTO nach dem Stand der Technik;
- Fig. 2: im Querschnitt den inneren Aufbau eines bekannten koaxialen GTO mit ringförmigem, niederinduktiven Gateanschluss;
- Fig. 3: in der Draufsicht eine Baugruppe aus koaxialem GTO und einer direkt angeschlossen Gateeinheit für die harte Ansteuerung nach dem Stand der Technik, und
- Fig. 4: in einer Schnittansicht den GTO nach Fig. 2 mit einer Gateeinheit gemäss einem bevorzugten Ausführungsbeispiel der vorliegenden Erfindung.

### WEGE ZUR AUSFÜHRUNG DER ERFINDUNG

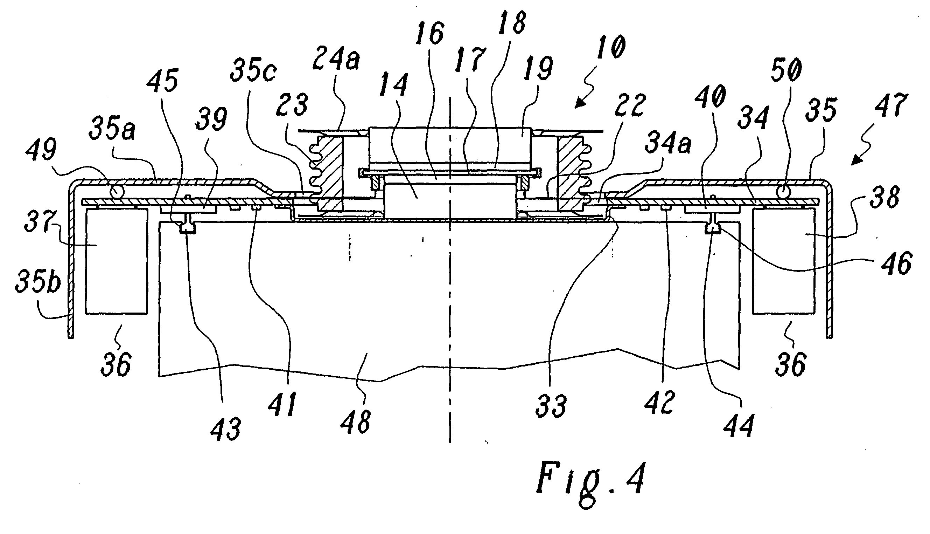

In Fig. 4 ist in einer Schnittansicht der bekannte GTO nach Fig. 2 mit einer Gateeinheit 47 gemäss einem bevorzugten Ausführungsbeispiel der vorliegenden Erfindung dargestellt. Für den GTO 10 sind dabei dieselben Bezugszeichen verwendet worden wie bei der Fig. 2. Unterschiedlich ist hier nur, dass der GTO 10 gegenüber der Darstellung aus Fig. 2 um 180° verdreht angeordnet ist, d.h., mit dem Kathodenkontakt 14 nach unten bzw. dem Anodenkontakt nach oben.

Der koaxiale (rotationssymmetrisch aufgebaute) GTO 10 ist ringförmig von einer (in der Regel mehrschichtigen) Leiterplatte 34 umgeben, die parallel zur Ebene des Halbleitersubstrats 17 auf der Höhe des Gateanschlusses 22 angeordnet ist. Die Leiterplatte 34 ist seitenverkehrt eingebaut, d.h. die von ihr getragenen und miteinander verbundenen Bauelemente 37, .., 42 sind auf der Unterseite angeordnet. Die Bauelemente 37, ..., 42 sind damit überwiegend zum kathodenseitigen Kühler 48 orientiert, der im thermischen Kontakt mit dem Kathodenkontakt 14 des GTO 10 steht und als Wasserkühler oder auch als Luftkühler ausgebildet sein kann. Der Kühler 48 übernimmt so mit seinen Metallteilen neben der Kühlfunktion gleichzeitig auf seiner Seite der Leiterplatte 34 eine elektrische Abschirmfunktion für die Bauelemente 37, ..., 42. Auf der anderen Seite der Leiterplatte 34 kann als Abschirmung grundsätzlich eine vorhandene Metallisierung der Leiterplatte 34 verwendet werden. Dies bietet sich dann an, wenn (bei einem relativ kleinen GTO 10) die Leiterplatte 34 selbst ausreichend stabil ist, um den angeschlossenen GTO 10 beim Handling sicher tragen zu können.

Bei einem grossen und (mehr als 1 kg) schweren GTO 10 jedoch wird zur weiteren Abschirmung, zur weiteren mechanischen Stabilisierung und zum besseren Handling der Einheit auf der dem Kühler 48 abgewandten Seite der Leiterplatte 34 eine Schale 35 aus Metallblech vorgesehen, die vorzugsweise einen im wesentlichen ebenen Boden 35a und eine vom Boden 35a abgewinkelte Seitenwand 35b aufweist. Die Schale 35 ist mit den Boden 35a parallel zur Leiterplatte 34 zwischen der Leiterplatte 34 und der Anodenseite des GTO 10 angeordnet. Die Seitenwand 35b umgibt die Leiterplatte 34 seitlich. Die Schale 35 hat im Boden 35a ein zentrales Loch 35c, durch welches der GTO 10 hindurchreicht. Sie ist mit dem Boden 35a, insbesondere mit dem leicht nach unten gebogenen Rand des Loches 35c, auf der Leiterplatte 34 befestigt und trägt so wesentlich zur mechanischen Stabilität der Anordnung bei. Zur Verbesserung der Stützwirkung können weiter aussen zwischen der Leiterplatte 34 und der Schale 35 zusätzliche Abstützungsmittel, insbesondere in Form von Silikontropfen 49, 50 oder dgl., vorgesehen werden.

Die Gateeinheit 47 umfasst elektronische Bauelemente unterschiedlicher Grösse wie z.B. SMD-Widerstände, MOSFET-Schalter oder Elkos für die Impulsstromversorgung. Je nach Grösse werden diese Bauelemente vorzugsweise an unterschiedlichen Plätzen zwischen der Leiterplatte 34 und dem Kühler 48 angeordnet. Für flache Bauelemente wie die Widerstände 41, 42 oder die MOSFETs 39, 40 reicht es aus, dass die Leiterplatte 34 von dem kathodenseitigen Kühler 48 beabstandet ist, und dass dieser Teil der Bauelemente direkt zwischen der Leiterplatte 34 und dem Kühler 48 angeordnet ist. Hierdurch wird bei gleichzeitig sehr guter Abschirmung viel Platz gespart. Für hohe Bauelemente wie die Elkos 37, 38 wird die Leiterplatte 34 vorzugsweise seitlich über den kathodenseitigen Kühler 48 hinausragend ausgebildet. Die Schale 35 umschliesst mit ihrer Seitenwand 35b auch einen Teil des Kühlers 48, derart, dass zwischen dem Kühler 48 und der Schale 35 bzw. der Seitenwand 35b der Schale ein Zwischenraum 36 frei bleibt. In diesem Zwischenraum 36 wird dann dieser Teil der Bauelemente in unmittelbarer Nähe des Kühlers 48 angeordnet.

Hat der Kühler 48 einen rechteckigen Querschnitt, werden die Elektrolytkondensatoren 37, 38 vorzugsweise an wenigstens zwei (insbesondere gegenüberliegenden) Seiten des Kühlers 48 angeordnet. Hat der Kühler 48 einen kreisförmigen Querschnitt, werden die Elektrolytkondensatoren 37, 38 vorzugsweise ringförmig um den Kühler 48 herum angeordnet. In beiden Fällen ergibt sich bei kompaktem Aufbau eine gleichmässige Verteilung des Gewichtes.

Zur weiteren Erhöhung der Stabilität kann eine lösbare Befestigung der Leiterplatte 34 an dem Kühler vorgesehen werden. Hierzu werden an der Leiterplatte 34 Befestigungselemente 43, 44, beispielsweise in Form von Schienen oder Führungsbolzen, angeordnet, mittels derer die Leiterplatte 34 an Befestigungsvorrichtungen 45, 46, beispielsweise in Form von Schienen, an dem darunterliegenden Kühler 48 befestigbar ist. Es ist aber ebensogut denkbar, dass am Kühler Klammern befestigt sind, in welche die Leiterplatte 34 bei der Montage des Stacks einrastend einschnappt.

Die Leiterplatte 34 weist im übrigen in ihrem Zentrum zur Aufnahme des GTO 10 ein Loch 34a auf. Das Loch 34a ist vorzugsweise mit einer elektrisch leitenden Wanne 33 (aus Metallblech) verschlossen, in welche der GTO 10 mit seinem Kathodenkontakt 14 einsetzbar ist, und welche den Kathodenkontakt 14 mit der Leiterplatte 34 bzw. der Gateeinheit 47 elektrisch verbindet. Die Wanne 33 ist dazu auf der Unterseite der Leiterplatte (34) angeschlossen bzw. befestigt. Der GTO 10 wird schliesslich mit seinem ringförmigen Gateanschluss 22 zusammen mit der Schale 35 auf der Oberseite der Leiterplatte 34 angeschlossen.

Im Rahmen der Erfindung kann die Gateeinheit 47 in vielfältiger Weise von dem in Fig. 4 dargestellten Ausführungsbeispiel abweichend realisiert werden. So können in dem Zwischenraum 36 neben den Elkos 37, 38 zusätzlich auch die Eingangsverstärker und optischen Koppelelemente untergebracht werden. Weiterhin ist es denkbar, die für die den Betrieb der Gateeinheit erforderliche Logik auf einer separaten SMD-Platine anzuordnen, die senkrecht auf der als Mutterplatine wirkenden Leiterplatte 34 aufgesetzt ist. Schliesslich können aber auch die Logiken für die verschiedenen Gateeinheiten eines Umrichters und die Speiseteile an einer zentralen Stelle im Umrichter ausserhalb der Gateeinheiten angeordnet werden. Hierdurch wird der Anschluss der optischen Ansteuerverbindungen (Opto-Links) und die Verriegelung zwischen den einzelnen Gateeinheiten wesentlich vereinfacht.

Insgesamt ergibt sich mit der Erfindung eine Gateeinheit, die sich durch folgende Merkmale und Vorteile auszeichnet:
- die Gateeinheit ist klein;
- sie umschliesst den GTO und bildet mit dem (kathodenseitigen) Kühler eine Einheit;
- der Anschluss zur Kathode des GTO kann besonders kostengünstig hergestellt werden;
- die Abschirmung der Gateeinheit gegenüber der Anode kann in einem Schritt hergestellt werden; sie erfüllt zwei Aufgaben im Betrieb (Stützung und Abschirmung) und trägt den GTO und die Gateeinheit beim Handling;
- die Einheit aus Gateeinheit und GTO kann weiterhin in den Stapel geschoben werden; und
- die schweren Komponenten sind mechanisch optimal fixierbar.

### BEZEICHNUNGSLISTE

- 10: GTO (Gate Turn Off Thyristor)
- 11: Streuinduktivität
- 12: Spannungsquelle (Einschaltkreis)
- 13: Spannungsquelle (Ausschaltkreis)
- 14: Kathodenkontakt
- 15a,24a: Deckel
- 15b,24b: Flansch
- 16,18: Mo-Scheibe
- 17: Halbleitersubstrat
- 19: Anodenkontakt
- 20: Randpassivierung
- 21: Gatekontakt (ringförmig)
- 22: Gateanschluss
- 23: Isoliergehäuse (z.B. Keramik)
- 25: GTO (koaxial)
- 26: Gateanschluss
- 27: Anodenkontakt
- 28: Gateeinheit
- 29: Leiterplatte
- 30: Bauelement (elektronisch)
- 31: Anschlussbereich
- 32: Gehäuse (Gateeinheit)
- 33: Wanne
- 34: Leiterplatte
- 34a: Loch (Leiterplatte)
- 35: Schale (Abschirmung)
- 35a: Boden (Schale)
- 35b: Seitenwand (Schale)
- 35c: Loch (Schale)
- 36: Zwischenraum (Kühler-Schale)
- 37, 38: Elektrolytkondensator
- 39,40: MOSFET
- 41,42: Bauelement (Widerstand etc.)
- 43,44: Befestigungselement
- 45, 46: Befestigungsvorrichtung (Befestigungselement)
- 47: Gateeinheit
- 48: Kühler
- 49,50: Silikontropfen
- A: Anode (GTO)
- C1,C2: Kondensator
- D1, .., D3: Diode
- G: Gate (GTO)
- K: Kathode (GTO)
- R1,R2: Widerstand
- S1, .., S4: Schalter (z.B. MOSFET)

## Patentansprüche

1. Baugruppe aus Kühler (48), GTO (10) und Gateeinheit (47) für einen hart angesteuerten GTO (10), bei welcher Gateeinheit (47) zumindest ein Teil der für die Ansteuerung benötigten elektronischen Bauelemente (37, .., 42) auf einer Leiterplatte (34) angeordnet und von einer Abschirmung (35) umgeben ist, welche Leiterplatte zur niederinduktiven Kontaktierung in einer zwischen der Anodenseite und Kathodenseite des GTO (10) liegenden Ebene parallel zum Halbleitersubstrat (17) den GTO (10) umschliesst und mit dem Kathodenkontakt (14) und dem Gateanschluss (22) des GTO (10) direkt verbindbar ist, und welcher GTO (10) kathodenseitig an den Kühler (48) angrenzt, **dadurch gekennzeichnet, dass** die Bauelemente (37, .., 42) auf der Leiterplatte (34) derart in unmittelbarer Nähe des GTO (10) angeordnet sind, dass zumindest ein Teil der Bauteile (37, .., 42) auf einem den Kühler (48) überdeckenden Teil der Leiterplatte (34) und auf der dem Kühler zugewandten Seite der Leiterplatte (34) angeordnet ist.

2. Baugruppe nach Anspruch 1, **dadurch gekennzeichnet, dass** die Leiterplatte (34) seitlich über den kathodenseitigen Kühler (48) hinausragt, dass die auf der Leiterplatte (34) angeordneten elektronischen Bauelemente eine Mehrzahl von Kondensatoren, insbesondere Elektrolytkondensatoren (37, 38), umfassen, welche innerhalb der Gateeinheit (47) eine Stromquelle für einen impulsförmigen Gatestrom des GTO (10) bilden, und dass die Kondensatoren (37, 38) auf dem den Kühler (48) überragenden Teil der Leiterplatte (34) seitlich vom Kühler (48) angeordnet sind.

3. Baugruppe nach Anspruch 2, **dadurch gekennzeichnet, dass** der Kühler (48) einen rechteckigen Querschnitt aufweist, und dass die Kondensatoren bzw. Elektrolytkondensatoren (37, 38) an wenigstens zwei Seiten des Kühlers (48) angeordnet sind.

4. Baugruppe nach Anspruch 2, **dadurch gekennzeichnet, dass** der Kühler (48) einen kreisförmigen Querschnitt aufweist, und dass die Kondensatoren bzw. Elektrolytkondensatoren (37, 38) ringförmig um den Kühler (48) herum angeordnet sind.

5. Baugruppe nach Anspruch 1, **dadurch gekennzeichnet, dass** die Leiterplatte (34) von dem kathodenseitigen Kühler (48) beabstandet ist, und dass ein Teil der Bauelemente (37, .., 42) zwischen der Leiterplatte (34) und dem Kühler (48) angeordnet ist.

6. Baugruppe nach einem der Ansprüche 1 und 5, **dadurch gekennzeichnet, dass** die Leiterplatte (34) auf der der Kathodenseite des GTO (10) abgewandten Seite mit einer Metallisierung versehen ist, und dass die Metallisierung als Abschirmung der Gateeinheit (47) verwendet wird.

7. Baugruppe nach einem der Ansprüche 1 bis 5, **dadurch gekennzeichnet, dass** zur Abschirmung der Bauelemente (37, .., 42) eine elektrisch leitende Schale (35) vorgesehen ist, welche den GTO (10) seitlich umschliesst und die mit den Bauelementen (37, .., 42) bestückte Leiterplatte (34) auf der der Kathodenseite des GTO (10) abgewandten Seite überdeckt.

8. Baugruppe nach Anspruch 7, **dadurch gekennzeichnet, dass** die Schale (35) einen im wesentlichen ebenen Boden (35a) und eine vom Boden (35a) abgewinkelte Seitenwand (35b) aufweist, dass die Schale (35) mit dem Boden (35a) parallel zur Leiterplatte (34) zwischen der Leiterplatte (34) und der Anodenseite des GTO (10) angeordnet ist, und dass die Seitenwand (35b) die Leiterplatte (34) seitlich umgibt.

9. Baugruppe nach Anspruch 8, **dadurch gekennzeichnet, dass** die Schale (35) mit dem Boden (35a) auf der Leiterplatte (34) befestigt ist.

10. Baugruppe nach einem der Ansprüche 7 bis 9, **dadurch gekennzeichnet, dass** die Schale (35) aus einem Metallblech geformt ist.

11. Baugruppe nach Anspruch 8, **dadurch gekennzeichnet, dass** die Leiterplatte (34) seitlich über den kathodenseitigen Kühler (48) hinausragt, dass die Schale (35) mit ihrer Seitenwand (35b) auch einen Teil des Kühlers (48) umschliesst, derart, dass zwischen dem Kühler (48) und der Schale (35) bzw. der Seitenwand (35b) der Schale ein Zwischenraum (36) frei bleibt, und dass ein Teil der Bauelemente (37,..,42) in dem Zwischenraum (36) angeordnet ist.

12. Baugruppe nach einem der Ansprüche 1 bis 11, **dadurch gekennzeichnet, dass** die Leiterplatte (34) in ihrem Zentrum zur Aufnahme des GTO (10) ein Loch (34a) aufweist, und dass das Loch (34a) mit einer elektrisch leitenden Wanne (33) verschlossen ist, in welche der GTO (10) mit seinem Kathodenkontakt (14) einsetzbar ist, und welche den Kathodenkontakt 14 mit der Leiterplatte (34) bzw. der Gateeinheit (47) elektrisch verbindet.

13. Baugruppe nach Anspruch 12, **dadurch gekennzeichnet, dass** die Wanne (33) auf der Unterseite der Leiterplatte (34) angeschlossen bzw. befestigt ist, und dass der GTO (10) mit seinem ringförmigen Gateanschluss (22) auf der Oberseite der Leiterplatte (34) angeschlossen wird.

14. Baugruppe nach einem der Ansprüche 1 bis 13, **dadurch gekennzeichnet, dass** an der Leiterplatte (34) Befestigungselemente (43, 44) angeordnet sind, mittels derer die Leiterplatte (34) an dem darunter liegenden Kühler (48) befestigbar ist.

15. Baugruppe nach einem der Ansprüche 7 bis 11, da**dadurch gekennzeichnet, dass** zusätzliche Mittel (49,50) zur Abstützung der Leiterplatte (34) an der Schale (35) vorgesehen sind.

## Claims

1. Subassembly of cooler (48), GTO (10) and gate unit (47) for a hard-driven GTO (10), in which gate unit (47) at least some of the electronic components (37, .., 42) needed for driving are arranged on a printed circuit board and surrounded by a shield (35), said printed circuit board enclosing the GTO (10), in order to achieve low-inductance contact, in a plane lying between the anode side and the cathode side of the GTO (10) parallel to the semiconductor substrate (17) and being able to be directly connected to the cathode contact (14) and the gate connection (22) of the GTO (10), and which GTO (10) has its cathode adjoining the cooler (48), **characterized in that** the components (37, ..., 42) are arranged on the printed circuit board (34) in direct proximity to the GTO (10) such that at least some of the components (37, ..., 42) are arranged on a part of the printed circuit board (34) which covers the cooler (48) and on that side of the printed circuit board (34) which faces the cooler.

2. Subassembly according to Claim 1, **characterized in that** the printed circuit board (34) protrudes laterally beyond the cooler (48) that is on the cathode side, **in that** the electronic components arranged on the printed circuit board (34) comprise a plurality of capacitors, particularly electrolytic capacitors (37, 38), which form a current source, inside the gate unit (47), for a pulsed gate current in the GTO (10), and **in that** the capacitors (37, 38) are arranged on the side of the cooler (48) on that part of the printed circuit board (34) which protrudes beyond the cooler (48).

3. Subassembly according to Claim 2, **characterized in that** the cooler (48) has a rectangular cross section, and **in that** the capacitors or electrolytic capacitors (37, 38) are arranged on at least two sides of the cooler (48).

4. Subassembly according to Claim 2, **characterized in that** the cooler (48) has a circular cross section, and **in that** the capacitors or electrolytic capacitors (37, 38) are arranged in a ring around the cooler (48).

5. Subassembly according to Claim 1, **characterized in that** the printed circuit board (34) is spaced apart from the cooler (48) that is on the cathode side, and **in that** some of the components (37, .., 42) are arranged between the printed circuit board (34) and the cooler (48).

6. Subassembly according to one of Claims 1 or 5, **characterized in that** the printed circuit board (34) is provided with metallization on that side which faces away from the cathode side of the GTO (10), and **in that** the metallization is used as a shield for the gate unit (47).

7. Subassembly according to one of Claims 1 to 5, **characterized in that** an electrically conductive casing (35) is provided in order to shield the components (37, .., 42), said casing laterally enclosing the GTO (10) and covering the printed circuit board (34), fitted with the components (37, .., 42), on that side which faces away from the cathode side of the GTO (10).

8. Subassembly according to Claim 7, **characterized in that** the casing (35) has an even base (35a) and a side wall (35b) angled from the base (35a), **in that** the casing (35) is arranged between the printed circuit board (34) and the anode side of the GTO (10) with its base (35a) parallel to the printed circuit board (34), and **in that** the side wall (35b) laterally surrounds the printed circuit board (34).

9. Subassembly according to Claim 8, **characterized in that** the casing (35) is fastened to the printed circuit board (34) by its base (35a).

10. Subassembly according to one of Claims 7 to 9, **characterized in that** the casing (35) is formed from a metal sheet.

11. Subassembly according to Claim 8, **characterized in that** the printed circuit board (34) protrudes laterally beyond the cooler (48) that is on the cathode side, **in that** the side wall (35b) of the casing (35) also encloses a part of the cooler (48) in such a way that an interspace (36) remains open between the cooler (48) and the casing (35) or the side wall (35b) of the casing, and **in that** some of the components (37, ..,42) are arranged in the interspace (36).

12. Subassembly according to one of Claims 1 to 11, **characterized in that** the printed circuit board (34) has a hole (34a) in its centre for accommodating the GTO (10), and **in that** the hole (34a) is closed off with an electrically conductive trough (33) into which the cathode contact (14) of the GTO (10) can be inserted and which electrically connects the cathode contact (14) to the printed circuit board (34) and the gate unit (47).

13. Subassembly according to Claim 12, **characterized in that** the trough (33) is connected or fastened on the underside of the printed circuit board (34), and **in that** the GTO (10) is connected to the topside of the printed circuit board (34) by means of its annular gate connection (22).

14. Subassembly according to one of Claims 1 to 13, **characterized in that** fastening elements (43, 44) are arranged on the printed circuit board (34) and can be used to fasten the printed circuit board (34) to the cooler (48) lying beneath it.

15. Subassembly according to one of Claims 7 to 11, **characterized in that** additional means (49, 50) are provided for supporting the printed circuit board (34) on the casing (35).

## Revendications

1. Sous-ensemble composé d'un radiateur (48), d'un GTO (10) et d'une unité de gâchette (47) pour un GTO à commande forcée (10), unité de gâchette (47) avec laquelle au moins une partie des composants électroniques (37, ..., 42) nécessaires pour la commande est disposée sur un circuit imprimé (34) et entourée d'un blindage (35), lequel circuit imprimé, en vue d'établir un contact à faible inductance, est enfermé dans un plan parallèle au substrat semiconducteur (17) du GTO (10) qui se trouve entre le côté anode et le côté cathode du GTO (10) et peut être relié avec le contact de cathode (14) et la borne de gâchette (22) du GTO (10), et lequel GTO (10) est adjacent au radiateur (48) du côté de l'anode, **caractérisé en ce que** les composants (37, ..., 42) sont disposés sur le circuit imprimé (34) à proximité immédiate du GTO (10) de telle sorte qu'au moins une partie des composants (37, ..., 42) est disposée sur une partie du circuit imprimé (34) qui recouvre le radiateur (48) et sur le côté du circuit imprimé (34) qui fait face au radiateur (48).

2. Sous-ensemble selon la revendication 1, **caractérisé en ce que** le circuit imprimé (34) fait saillie latéralement au-dessus du radiateur (48) côté cathode, que les composants électroniques disposés sur le circuit imprimé (34) comprennent une pluralité de condensateurs, notamment de condensateurs électrolytiques (37, 38) qui forment, au sein de l'unité de gâchette (47), une source de courant pour le courant de gâchette impulsionnel du GTO (10), et que les condensateurs (37, 38) sont disposés sur la partie du circuit imprimé (34) qui fait saillie latéralement par rapport au radiateur (48).

3. Sous-ensemble selon la revendication 2, **caractérisé en ce que** le radiateur (48) présente une section transversale rectangulaire et que les condensateurs ou les condensateurs électrolytiques (37, 38) sont disposés sur au moins deux côtés du radiateur (48).

4. Sous-ensemble selon la revendication 2, **caractérisé en ce que** le radiateur (48) présente une section transversale circulaire et que les condensateurs ou les condensateurs électrolytiques (37, 38) sont disposés de manière annulaire autour du radiateur (48).

5. Sous-ensemble selon la revendication 1, **caractérisé en ce que** le circuit imprimé (34) est espacé du radiateur (48) côté cathode et qu'une partie des composants (37, ..., 42) est disposée entre le circuit imprimé (34) et le radiateur (48).

6. Sous-ensemble selon l'une des revendications 1 et 5, **caractérisé en ce que** le circuit imprimé (34) est muni d'une métallisation sur le côté opposé au côté cathode du GTO (10) et que la métallisation est utilisée comme blindage de l'unité de gâchette (47).

7. Sous-ensemble selon l'une des revendications 1 à 5, **caractérisé en ce que** pour le blindage des composants (37, ..., 42), il est prévu une coque (35) électriquement conductrice qui entoure le GTO (10) latéralement et qui recouvre le circuit imprimé (34) équipé des composants (37, ..., 42) sur le côté cathode du GTO (10).

8. Sous-ensemble selon la revendication 7, **caractérisé en ce que** la coque (35) présente un fond plan (35a) et une paroi latérale (35b) pliée par rapport au fond (35a), que la coque (35) est disposée avec le fond (35a) parallèle au circuit imprimé (34) entre le circuit imprimé (34) et le côté anode du GTO (10) et que la paroi latérale (35b) entoure latéralement le circuit imprimé (34).

9. Sous-ensemble selon la revendication 8, **caractérisé en ce que** la coque (35) est fixée avec le fond (35a) sur le circuit imprimé (34).

10. Sous-ensemble selon l'une des revendications 7 à 9, **caractérisé en ce que** la coque (35) est façonnée à partir d'une tôle de métal.

11. Sous-ensemble selon la revendication 8, **caractérisé en ce que** le circuit imprimé (34) fait saillie latéralement au-dessus du radiateur (48) côté cathode, que la coque (35) entoure également une partie du radiateur (48) avec sa paroi latérale (35b) de telle sorte qu'entre le radiateur (48) et la coque (35) ou la paroi latérale (35b) de la coque il demeure un espace intermédiaire (36) libre et qu'une partie des composants (37, ..., 42) est disposée dans l'espace intermédiaire (36).

12. Sous-ensemble selon l'une des revendications 1 à 11, **caractérisé en ce que** le circuit imprimé (34) présente en son centre un trou (34a) pour recevoir le GTO (10), et que le trou (34a) est fermé par une cuvette (33) électriquement conductrice dans laquelle peut être introduit le GTO (10) avec son contact de cathode (14) et qui relie électriquement le contact de cathode (14) avec le circuit imprimé (34) ou l'unité de gâchette (47).

13. Sous-ensemble selon la revendication 12, **caractérisé en ce que** la cuvette (33) est raccordée ou fixée sur le côté inférieur du circuit imprimé (34) et que le GTO (10) est raccordé sur le côté supérieur du circuit imprimé (34) avec sa borne de gâchette (22) de forme annulaire.

14. Sous-ensemble selon l'une des revendications 1 à 13, **caractérisé en ce que** sur le circuit imprimé (34) sont disposés des éléments de fixation (43, 44) au moyen desquels le circuit imprimé (34) peut être fixé sur le radiateur (48) qui se trouve au-dessous.

15. Sous-ensemble selon l'une des revendications 7 à 11, **caractérisé en ce que** des moyens supplémentaires (49, 50) sont prévus pour soutenir le circuit imprimé (34) sur la coque (35).
